(19) Europäisches Patentamt European Patent Office Office européen des brevets

(11) **EP 3 742 616 B1**

(12) **FASCICULE DE BREVET EUROPEEN**

(45) Date de publication et mention de la délivrance du brevet:
**16.02.2022 Bulletin 2022/07**

(21) Numéro de dépôt: **20175524.6**

(22) Date de dépôt: **19.05.2020**

(51) Classification Internationale des Brevets (IPC):
**H03M 1/80** *(2006.01)* **H03M 1/10** *(2006.01)*
**H01L 27/00** *(2006.01)* **H01G 4/40** *(2006.01)*

(52) Classification Coopérative des Brevets (CPC):
**H03M 1/806; H03M 1/1061;** G01R 31/013;
G01R 31/2856

(54) **CORRECTION D'UNE VALEUR D'UN COMPOSANT PASSIF**

KORREKTUR DES WERTES EINER PASSIVEN KOMPONENTE

CORRECTION OF A VALUE OF A PASSIVE COMPONENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.05.2019 FR 1905330**

(43) Date de publication de la demande:
**25.11.2020 Bulletin 2020/48**

(73) Titulaire: **Commissariat à l'Energie Atomique et aux Energies Alternatives**
**75015 Paris (FR)**

(72) Inventeurs:
• **AUDEBERT, Patrick**
**38054 GRENOBLE CEDEX 9 (FR)**
• **BILLIOT, Gérard**
**38054 GRENOBLE CEDEX 9 (FR)**

(74) Mandataire: **Cabinet Beaumont**
**4, Place Robert Schuman**
**B.P. 1529**
**38025 Grenoble Cedex 1 (FR)**

(56) Documents cités:
**US-A1- 2002 034 932 US-A1- 2005 116 845**

• **LEME C A ET AL: "Efficient calibration of binary-weighted networks using a mixed analogue-digital RAM", SIGNAL IMAGE AND VIDEO PROCESSING. SINGAPORE, JUNE 11 -14, 1991; [PROCEEDINGS OF THE INTERNATIONAL SYMPOSIUM ON CIRCUITS AND SYSTEMS], IEEE, NEW YORK, NY, vol. SYMP. 24, 11 juin 1991 (1991-06-11), pages 1545-1548, XP010046497, DOI: 10.1109/ISCAS.1991.176671 ISBN: 978-0-7803-0050-7**
• **GOES J ET AL: "High-linearity calibration of low-resolution digital-to-analog converters", CIRCUITS AND SYSTEMS, 1994. ISCAS '94., 1994 IEEE INTERNATIONAL SYMPOS IUM ON LONDON, UK 30 MAY-2 JUNE 1994, NEW YORK, NY, USA,IEEE, US, vol. 5, 30 mai 1994 (1994-05-30), pages 345-348, XP010143337, DOI: 10.1109/ISCAS.1994.409378 ISBN: 978-0-7803-1915-8**

**EP 3 742 616 B1**

## Description

Domaine technique

La présente description concerne de façon générale les circuits électroniques intégrés, et plus particulièrement les composants passifs, par exemple des résistances, des capacités et des inductances, de ces circuits intégrés.

Technique antérieure

On connaît des circuits électroniques intégrés comprenant au moins un composant passif réalisé à partir de composants passifs unitaires identiques. Pour limiter la surface occupée par de tels circuits électroniques intégrés et la consommation de ces circuits, on cherche généralement à réaliser le composant passif à partir de composants passifs unitaires ayant des valeurs faibles, donc des dimensions faibles. Toutefois, plus les dimensions des composants passifs unitaires sont petites, plus les dispersions de fabrication sur la valeur du composant réalisé à partir de ces composants unitaires sont importantes et peuvent conduire à un écart significatif entre la valeur cible ou théorique du composant et la valeur réelle ou pratique du composant fabriqué. Le document US 2002/034932 A1 divulgue des circuits à base de condensateurs/commutateurs qui, quand ils sont connectés ensemble en parallèle, fournissent une capacité totale égale à la somme de tous les condensateurs ayant des commutateurs respectifs dans l'état "on", dans lequel le choix des coefficients de pondération définit quelles capacités sont disponibles. Un schéma de pondération égale, un schéma de pondération binaire, des schémas de pondération radix moins de deux et radix mixte sont divulgués.

Résumé de l'invention

Il existe un besoin de corriger, dans un circuit électronique intégré, l'écart entre la valeur théorique ou cible et la valeur pratique d'un composant passif réalisé à partir de plusieurs composants passifs unitaires.
Un mode de réalisation pallie tout ou partie des inconvénients des composants passifs intégrés connus, et en particulier de la correction de la valeur pratique de ces composants passifs intégrés connus.
Un mode de réalisation prévoit un circuit intégré comprenant un premier composant passif de type capacitif, résistif ou inductif comportant :

une pluralité de deuxièmes et troisièmes composants passifs dudit type ayant chacun une même première valeur théorique Compu_t, les deuxièmes composants étant connectés entre eux de sorte que leurs valeurs s'ajoutent, et chaque troisième composant étant associé à un premier interrupteur dont l'état détermine si la valeur du troisième composant s'ajoute aux valeurs des deuxièmes composants ; et

une pluralité de quatrièmes composants passifs dudit type chacun associé à un deuxième interrupteur dont l'état détermine si la valeur du quatrième composant s'ajoute aux valeurs des deuxièmes composants, au moins un des quatrièmes composants passifs ayant une deuxième valeur théorique égale à $(1-P).Compu\_t$ ou à $(1+P).Compu\_t$, avec P positif strictement inférieur à 1/2.

Selon un mode de réalisation, le premier composant a une valeur cible égale à $M.Compu\_t$, avec M entier, de préférence supérieur ou égal à 1/P.
Selon un mode de réalisation, $P.Compu\_t$ détermine un écart maximal désiré entre une valeur pratique et une valeur cible du premier composant ou une valeur pratique d'un cinquième composant passif, les premier et cinquième composants ayant la même valeur cible et étant du même type.
Selon un mode de réalisation, le circuit intégré comprend en outre un circuit de mesure configuré pour fournir un signal représentatif d'un écart entre la valeur pratique du premier composant et la valeur cible du premier composant ou la valeur pratique du cinquième composant.
Selon un mode de réalisation, le circuit intégré comprend en outre un circuit de commande des premiers et deuxièmes interrupteurs, configuré pour sélectionner l'une quelconque des combinaisons possibles d'états des premiers et deuxièmes interrupteurs.
Selon un mode de réalisation, dans une phase de caractérisation du premier composant, le circuit de commande est configuré pour sélectionner successivement au moins certaines desdites combinaisons possibles d'états des premiers et deuxièmes interrupteurs, de préférence toutes lesdites combinaisons possibles d'états des premiers et deuxièmes interrupteurs.
Selon un mode de réalisation, dans une phase de correction, le circuit de commande est configuré pour sélectionner parmi les combinaisons sélectionnées pendant la phase de caractérisation, à partir du signal fourni par le circuit de mesure pour chaque combinaison sélectionnée pendant la phase de caractérisation, une combinaison d'états des premiers et deuxièmes interrupteurs correspondant à la valeur pratique du premier composant la plus proche de la valeur cible ou de la valeur pratique du cinquième composant.
Selon un mode de réalisation, lesdits composants sont de type capacitif, les deuxièmes composants étant connectés en parallèle les uns des autres, chaque troisième composant étant connecté en série avec le premier interrupteur auquel le troisième composant est associé, chaque quatrième composant étant connecté en série avec le deuxième interrupteur auquel le quatrième composant est associé, chaque association en série d'un troisième composant et d'un interrupteur et chaque association en série d'un quatrième composant et d'un interrupteur étant connectées en parallèle des deuxièmes composants.

Selon un mode de réalisation, P est inférieur ou égal à 1/3, de préférence à 1/4.

Selon un mode de réalisation, P est égal à 1/R, avec R entier.

Selon un mode de réalisation, le circuit intégré comprend M-R deuxièmes composants et R troisièmes composants.

Selon un mode de réalisation, le circuit intégré comprend R quatrièmes composants.

Selon un mode de réalisation, tous les quatrièmes composants ont la même deuxième valeur théorique.

Un autre mode de réalisation prévoit un convertisseur numérique analogique comprenant un circuit intégré tel que décrit.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente schématiquement un exemple de circuit comprenant des composants passifs chacun réalisé à partir de plusieurs composants passifs unitaires, du type auquel s'appliquent les modes de réalisation décrits ;

la figure 2 représente schématiquement un mode de réalisation d'un composant passif réalisé à partir de plusieurs composants passifs unitaires ;

la figure 3 représente, schématiquement et sous la forme de blocs, un mode de réalisation d'un circuit électronique comprenant un composant du type de celui de la figure 2 ;

la figure 4 représente, de manière plus détaillée, un mode de réalisation d'un composant du type de celui de la figure 2, dans le cas où le composant est de type capacitif ; et

la figure 5 représente schématiquement une variante de réalisation d'un composant du type de celui de la figure 2.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits intégrés et les applications usuelles dans lesquels sont prévus des composants passifs réalisés à partir de plusieurs composants passifs unitaires n'ont pas été détaillés, les modes de réalisation décrits étant compatibles avec ces circuits et applications usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Dans la suite de la description, sauf indication contraire, la référence d'un composant passif à laquelle est ajouté le suffixe "_p" désigne la valeur pratique du composant, et la référence du composant passif à laquelle est ajouté le suffixe "_t" désigne la valeur théorique ou cible de ce composant.

En outre, lorsque l'on fait référence à la tension d'un noeud ou d'un point, on considère ici qu'il s'agit de la tension entre ce noeud ou point et la masse, c'est-à-dire qu'il s'agit du potentiel de ce noeud ou point référencé à la masse.

Par ailleurs, on appelle "signal binaire" un signal qui alterne entre un premier état constant, par exemple un état bas, noté '0', et un deuxième état constant, par exemple un état haut, noté '1'. Les états haut et bas de signaux binaires différents d'un même circuit électronique peuvent être différents. En pratique, les signaux binaires peuvent correspondre à des tensions ou à des courants qui peuvent ne pas être parfaitement constants à l'état haut ou bas. En outre, on appelle mot binaire une information représentée par plusieurs bits, c'est-à-dire par plusieurs signaux binaires.

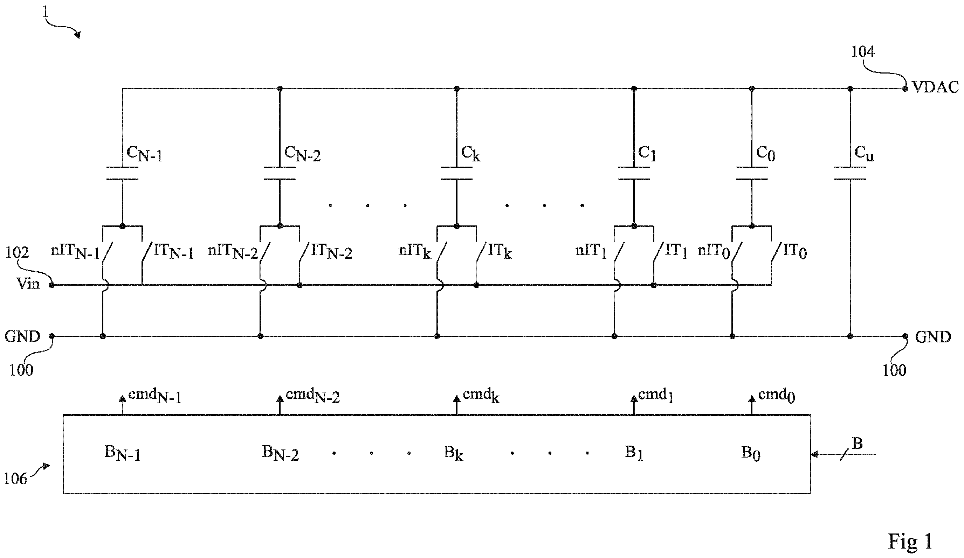

La figure 1 représente schématiquement un exemple de circuit 1 comprenant des composants passifs chacun réalisé à partir de plusieurs composants passifs unitaires, du type auquel s'appliquent les modes de réalisation décrits. Plus particulièrement, la figure 1 représente un convertisseur numérique-analogique capacitif, ou CDAC, 1 à pondération sur N bits, avec N entier supérieur à 2.

Le convertisseur 1 est configuré pour convertir un mot binaire B de N bits $B_{N-1}$, $B_{N-2}$, .., $B_k$, .., $B_1$, $B_0$, avec $B_{N-1}$ le bit de poids fort et $B_0$ le bit de poids faible, en un potentiel analogique VDAC. Le potentiel VDAC est compris entre un potentiel d'alimentation Vin et un potentiel de référence GND, typiquement la masse, le potentiel VDAC étant référencé au potentiel de référence GND. Le convertisseur 1 comprend un rail conducteur, ou noeud, 100 destiné à recevoir le potentiel de référence, et un rail conducteur, ou noeud, 102 destiné à recevoir le potentiel d'alimentation Vin. Le potentiel VDAC de sortie du convertisseur 1 est disponible au niveau d'un rail conducteur, ou noeud, 104.

Pour chaque bit $B_k$ du mot B, avec k entier compris entre 0 et N-1 et correspondant à l'indice du bit, le convertisseur 1 comprend un composant capacitif, ou capacité, $C_k$. Chaque capacité $C_k$ a une valeur théorique $C_{k\_}t$ égale à $2^k.C_{u\_}t$ où $C_u$ est un composant capacitif unitaire de valeur théorique $C_{u\_}t$. Ainsi, bien que cela ne soit pas représenté en figure 1, chaque capacité $C_k$ comprend $2^k$ capacités $C_u$ connectées en parallèle entre deux bornes constituant les deux bornes, ou électrodes, de la capacité $C_k$. Chaque capacité $C_k$ a une électrode connectée au rail 104, l'autre électrode de la capacité étant reliée au rail 102 par un interrupteur $IT_k$ ($IT_{N-1}$, $IT_{N-2}$, .., $IT_k$, .., $IT_1$, $IT_0$) et au rail 100 par un interrupteur $nIT_k$ ($nIT_{N-1}$, $nIT_{N-2}$, .., $nIT_k$, .., $nIT_1$, $nIT_0$). Une capacité unitaire $C_u$ est connectée entre le rail 104 et le rail 100.

Le convertisseur 1 comprend en outre un circuit 106 de commande des interrupteurs $nIT_k$ et $IT_k$. Le circuit 106 reçoit le mot binaire B et fournit les signaux binaires de commande des interrupteurs $IT_k$ et $nIT_k$. Plus particulièrement, dans cet exemple, le circuit 106 fournit N signaux binaires de commande $cmd_k$ ($cmd_{N-1}$, $cmd_{N-2}$, .., $cmd_k$, .., $cmd_1$, $cmd_0$), chaque interrupteur $IT_k$ recevant le signal $cmd_k$ et chaque interrupteur $nIT_k$ recevant le complément du signal $cmd_k$, par exemple par l'intermédiaire d'un inverseur non représenté en figure 1. Autrement dit, lorsque le signal $cmd_k$ est tel que l'interrupteur $IT_k$ est fermé, le complément du signal $cmd_k$ est tel que l'interrupteur $nIT_k$ est ouvert, et inversement.

En fonctionnement, pour chaque bit $B_k$ à '1', le circuit 106 fournit un signal $cmd_k$ tel que l'interrupteur $IT_k$ est fermé, et, pour chaque bit $B_k$ à '0', le circuit 106 fournit un signal $cmd_k$ tel que l'interrupteur $IT_k$ est ouvert. Ainsi, la tension VDAC théoriquement disponible sur le rail 104 peut s'écrire selon la formule Math. 1 suivante :

[Math 1]

$$VDAC = Vin.\frac{\sum_{k=0}^{N-1} B_k.C_{k\_}t}{C_{u\_}t + \sum_{k=0}^{N-1} C_{k\_}t}$$

la valeur de la tension VDAC, en volt, étant donc plus précisément comprise entre 0 et Vin.$(2^N-1)/2^N$.

On considère à titre d'exemple le cas où N est égal à 6. Le convertisseur 1 est alors configuré pour fournir, en fonction de la valeur du mot B, 64 valeurs de tension VDAC à un pas égal à Vin/64. Toutefois, en pratique, chaque capacité unitaire $C_u$ est sujette à des dispersions de fabrication. Il en résulte que chaque capacité $C_u$ peut avoir une valeur pratique $C_{u\_}p$, après fabrication, différente de sa valeur théorique $C_{u\_}t$. Ainsi, chaque capacité

$C_k$ peut avoir une valeur pratique $C_{k\_}p$, après fabrication, différente de sa valeur théorique $C_{k\_}t$. Ainsi, la différence entre deux tensions VDAC correspondant à deux valeurs successives du mot B peut ne pas être égale au pas Vin/64 attendu. Dans cet exemple, cela est plus particulièrement vrai pour les deux tensions VDAC correspondant aux deux mots B="011111" et B="100000", c'est-à-dire les deux mots binaires de valeurs successives qui mettent en jeu respectivement l'utilisation de l'ensemble des capacités $C_k$ à l'exception de la plus grosse capacité $C_{N-1}$ du CDAC 1, et l'utilisation de cette plus grosse capacité uniquement.

Pour pallier ces écarts entre la valeur pratique $C_{k\_}p$ et la valeur théorique $C_{k\_}t$ d'une capacité $C_k$, on pourrait penser réaliser la capacité $C_k$ avec un nombre X de capacités unitaires $C_u$ en parallèle supérieur à $2^k$, chacune associée à un interrupteur de manière à pouvoir sélectionner la combinaison de $2^k$ capacités $C_u$ parmi X conduisant à une valeur pratique $C_{k\_}p$ de la capacité $C_k$ la plus proche de la valeur théorique $C_{k\_}t$. La valeur cible $C_{k\_}t$ peut correspondre à la valeur pratique d'une autre capacité, typiquement la valeur de l'ensemble des capacités $C_0$ à $C_{k-1}$ en parallèle, lorsque l'on souhaite appairer la capacité $C_k$ avec cet ensemble de capacités en parallèle $C_0$ à $C_{k-1}$. Pour ces X capacités $C_u$, il faut prévoir X signaux de commande de sélection spécifiques, d'où il résulte une complexification de la structure, une augmentation de la surface du circuit 1, et une augmentation des capacités parasites liées à la connectique complexe de la structure. Notamment, ces capacités parasites limitent l'amplitude maximale atteignable de la tension VDAC.

Pour pallier ces écarts entre la valeur pratique $C_{k\_}p$ et la valeur théorique $C_{k\_}t$ d'une capacité $C_k$, on pourrait également penser prévoir des capacités de correction supplémentaires dont les valeurs théoriques seraient choisies égales $C_{u\_}t/2^1$, $C_{u\_}t/2^2$, $C_{u\_}t/2^3$ etc... Toutefois, les dispersions sur la valeur d'un composant passif, ici une capacité, étant d'autant plus importantes que la valeur, donc la surface, du composant est petite, les dispersions sur les valeurs des capacités de correction pourraient être plus grandes que les dispersions que l'on souhaite corriger sur la valeur de la capacité $C_k$. Plus particulièrement, les capacités unitaires $C_u$ étant généralement prévues pour avoir une valeur théorique $C_{u\_}t$ aussi faible que possible compte tenu de leur méthode de fabrication, les capacités de correction de valeur inférieure ou égale à $C_{u\_}t/2^m$, avec m entier supérieur ou égal à 1, peuvent alors être impossibles à fabriquer en raison des contraintes technologiques (dessin, gravure, etc.) associées à cette méthode de fabrication. Une solution pour fabriquer de telles capacités de correction serait d'associer en série plusieurs capacités unitaires $C_u$. Toutefois, cette connexion de plusieurs capacités unitaires Cu ajouterait des capacités parasites faussant la valeur $C_{u\_}t/2^m$ recherchée. En outre, cette solution augmenterait encore la surface du circuit 1. Par ailleurs, pour certaines technologies, la mise en oeuvre d'une telle connexion en série de capacités unitaires $C_u$ peut être diffi-

cile, voire impossible, comme c'est par exemple le cas quand les capacités unitaires $C_u$ du circuit 1 sont des capacités à doigts ("finger") réalisées selon une structure de peigne dans laquelle toutes les capacités $C_u$ ont une armature commune et sont donc prévues pour être connectées en parallèle et non en série.

On a présenté ici des problèmes liés à la correction de la valeur pratique $C_k\_p$ d'une capacité $C_k$ réalisée à partir de $2^k$ capacités unitaires de même valeur théorique $C_u\_t$. Plus généralement, des problèmes similaires se posent pour corriger la valeur pratique $Comp\_p$ d'un composant passif $Comp$ d'un type donné, par exemple résistif ou inductif, lorsque le composant $Comp$ est réalisé à partir de plusieurs composants passifs unitaires $Comp_u$ du même type que le composant $Comp$ et que la valeur théorique $Comp\_t$ du composant $Comp$ est égale à M fois la valeur théorique $Comp_u\_t$ des composants $Comp_u$.

Les inventeurs proposent ici de corriger la valeur pratique $Comp\_p$ d'un composant passif $Comp$ réalisé à partir de composants passifs unitaires $Comp_u$, au moyen de composants passifs de correction $Comp_{corr}$ tels qu'au moins l'un des composants de correction $Comp_{corr}$, de préférence au moins la moitié des composants de correction $Comp_{corr}$, encore plus préférentiellement tous les composants de correction $Comp_{corr}$, ont des valeurs théoriques $Comp_{corr}\_t$ proches mais différentes de la valeur théorique $Comp_u\_t$ des composants unitaires $Comp_u$. On notera que chaque composant $Comp_{corr}$ est alors réalisé par un unique composant, et non pas comme une association série et/ou parallèle de plusieurs composants unitaires $Comp_u$.

On considère ici qu'un composant $Comp_{corr}$ a une valeur théorique $Comp_{corr}\_t$ proche de la valeur théorique $Comp_u\_t$ d'un composant $Comp_u$ lorsque la valeur $Comp_{corr}\_t$ est égale à $(1 \pm P).Comp_u\_t$, avec P strictement positif et strictement inférieur à 1/2. De préférence, P est supérieur à 1/20, voire à 1/10. De préférence, P est inférieur à 1/3, voire à 1/4. La valeur $P.Comp_u\_t$ représente alors la précision recherchée sur la valeur pratique $Comp\_p$ corrigée du composant $Comp$. Autrement dit, $P.Comp_u\_t$ correspond à l'écart maximal visé entre la valeur théorique ou visée $Comp\_t$ et la valeur pratique $Comp\_p$ corrigée du composant $Comp$.

Des composants de correction $Comp_{corr}$ dont la valeur théorique $Comp_{corr}\_t$ est strictement supérieure à la moitié de la valeur théorique $Comp_u\_t$, de préférence supérieure ou égale à deux tiers de la valeur théorique $Comp_u\_t$, encore plus préférentiellement supérieure ou égale à trois quarts de la valeur théorique $Comp_u\_t$, permettent de limiter les dispersions de fabrication sur la valeur pratique $Comp_{corr}\_p$ du composant $Comp_{corr}$ par rapport au cas où ce composant $Comp_{corr}$ aurait une valeur théorique inférieure ou égale à la moitié de la valeur $Comp_u\_t$.

Des composants de correction $Comp_{corr}$ tels que définis ci-dessus permettent d'atteindre une précision égale à $P.Comp_u\_t$ sur la valeur pratique $Comp\_p$ corrigée du composant. En outre, par rapport à une sélection de $2^k$ composant $Comp_u$ parmi X composants $Comp_u$ pour corriger la valeur $Comp\_p$ d'un composant $Comp$ de valeur théorique $Comp\_t$ égale la valeur pratique $2^k.Comp_u\_t$, la correction de la valeur $Comp\_p$ avec des composants $Comp_{corr}$ tels que définis ci-dessus nécessite moins d'interconnexions et moins de signaux de commande de sélection, et conduit donc à une structure moins complexe. A titre d'exemple, il suffit de prévoir au moins 1/P composants $Comp_{corr}$ sélectionnables et de rendre sélectionnables au moins 1/P composants $Comp_u$ parmi les $2^k$ composants $Comp_u$ pour permettre une correction de la valeur $Comp\_p$ avec une précision de $P.Comp_u\_t$. L'augmentation des capacités parasites liées à cette structure reste très limitée et, dans le cas où cette structure est utilisée dans le convertisseur de la figure 1, cette augmentation des capacités parasites affecte peu l'amplitude maximale atteignable de la tension VDAC.

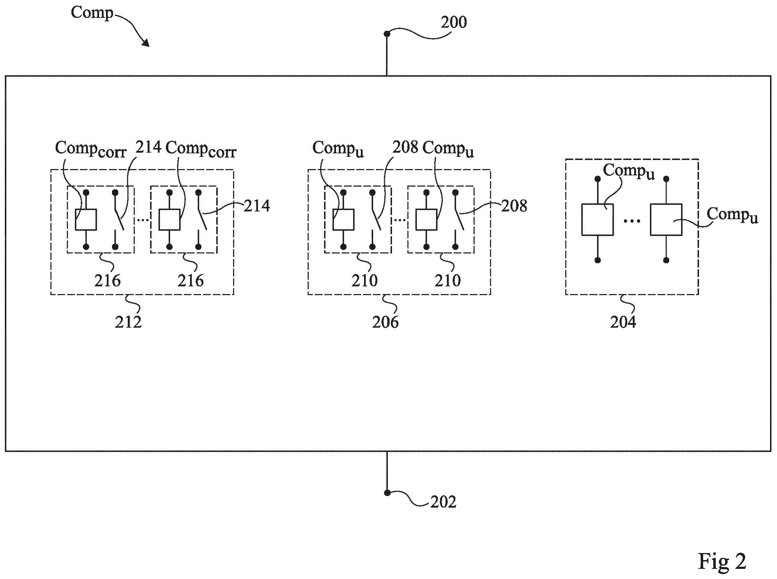

La figure 2 représente très schématiquement un mode de réalisation d'un composant passif résistif, inductif ou capacitif $Comp$ dont la valeur théorique $Comp\_t$ est égale à M fois la valeur théorique $Comp_u\_t$ d'un composant passif unitaire $Comp_u$ respectivement résistif, inductif ou capacitif, avec M entier positif, de préférence supérieur ou égal à 1/P, par exemple égal 128. Le composant $Comp$ est alors réalisé à partir d'au moins M, de préférence à partir de M, composants unitaires $Comp_u$ identiques. En outre, dans cet exemple, on cherche à obtenir un composant $Comp$ tel que sa valeur pratique $Comp\_p$ puisse être corrigée pour être égale à sa valeur théorique $Comp\_t$ avec un écart d'au plus 1/8 de $Comp_u\_t$. Autrement dit, dans cet exemple le nombre P est égal à 1/8.

Le composant $Comp$ comprend une première borne 200, et une deuxième borne 202. La valeur pratique $Comp\_p$ du composant passif $Comp$, par exemple la résistance, l'inductance ou la capacité selon le cas, est prise ou mesurée entre les bornes 200 et 202.

Le composant $Comp$ comprend une pluralité de composants unitaires $Comp_u$, dans cet exemple M composants $Comp_u$, dont seulement certains sont représentés en figure 2. Les composants unitaires $Comp_u$ sont répartis en deux ensembles 204 et 206, matérialisés par des cadres en pointillé en figure 2.

Dans l'ensemble 204, les composants $Comp_u$ sont connectés entre eux de sorte que, entre les bornes 200 et 202, leurs valeurs s'ajoutent. Autrement dit, entre les bornes 200 et 202, l'ensemble 204 de composants $Comp_u$ a une valeur théorique $M1.Comp_u\_t$, avec M1 entier strictement inférieur à M, M1 correspondant au nombre de composants $Comp_u$ de l'ensemble 204. Lorsque P est égal à 1/R avec R entier, M1 est de préférence égal à M-R, c'est-à-dire à M-8 dans cet exemple.

A titre d'exemple, dans le cas d'un composant $Comp$ et de composants $Comp_u$ résistifs, les M1 composants $Comp_u$ de l'ensemble 204 sont connectés en série, l'association en série des composants $Comp_u$ du premier

ensemble 204 étant reliée aux bornes 200 et 202.

Selon un autre exemple, dans le cas d'un composant Comp et de composants $Comp_u$ capacitifs, les M1 composants $Comp_u$ de l'ensemble 204 sont connectés en parallèle, l'association en parallèle des composants $Comp_u$ du premier ensemble 204 étant connectée aux bornes 200 et 202.

Dans l'ensemble 206, chaque composant $Comp_u$ est associé à un interrupteur 208. Chaque association 210 d'un composant $Comp_u$ et d'un interrupteur 208 est matérialisée par un cadre en pointillé en figure 2. Entre les bornes 200 et 202, les associations 210 sont connectées entre elles et, dans chaque association 210, le composant $Comp_u$ et l'interrupteur 208 sont connectés entre eux, de sorte que l'état ouvert ou fermé de l'interrupteur 208 détermine si la valeur du composant $Comp_u$ s'ajoute ou non à la somme des valeurs des M1 composants $Comp_u$ de l'ensemble 204. Autrement dit, entre les bornes 202 et 200, l'ensemble 206 a une valeur théorique égale à $j.Comp_u\_t$, avec j entier compris entre 0 et M2, M2 correspondant au nombre d'associations 210 de l'ensemble 206 et j étant déterminé par les états des interrupteurs 208. En outre, la valeur théorique de l'ensemble 206 s'ajoute à la valeur théorique de l'ensemble 204. De préférence, M1+M2 est égal à M. M2 est par exemple au moins égal à 1/P, de préférence égal à 1/P. Dans cet exemple, M2 est égal à 8.

A titre d'exemple, dans le cas d'un composant Comp et de composants $Comp_u$ résistifs, dans chaque association 210, l'interrupteur 208 est connecté en parallèle du composant $Comp_u$, et les M2 associations 210 sont connectées en série les unes avec les autres. L'association en série des M2 associations 210 est alors connectée en série avec l'association en série des M1 composants $Comp_u$ de l'ensemble 204. Autrement dit, les ensembles 204 et 206 sont connectés en série entre les bornes 200 et 202.

Selon un autre exemple, dans le cas d'un composant Comp et de composants $Comp_u$ capacitifs, dans chaque association 210, l'interrupteur 208 est connecté en série avec le composant $Comp_u$, et les M2 associations 210 sont connectées en parallèle les unes avec les autres. L'association en parallèle des M2 associations 210 est alors connectée en parallèle avec l'association en parallèle des M1 composants $Comp_u$ de l'ensemble 204. Autrement dit, les ensembles 204 et 206 sont connectés en parallèle entre les bornes 200 et 202.

Le composant Comp comprend en outre un ensemble 212 de plusieurs composants de correction $Comp_{corr}$. Chaque composant $Comp_{corr}$ est associé à un interrupteur 214. Chaque association 216 d'un composant $Comp_{corr}$ et d'un interrupteur 214 est matérialisée par un cadre en pointillé en figure 2. Entre les bornes 200 et 202, les associations 216 sont connectées entre elles et, dans chaque association 216, le composant $Comp_{corr}$ et l'interrupteur 214 sont connectés entre eux, de sorte que l'état ouvert ou fermé de l'interrupteur 214 détermine si la valeur du composant $Comp_{corr}$ s'ajoute ou non à la somme des valeurs des M1 composants $Comp_u$ de l'ensemble 204. Autrement dit, entre les bornes 202 et 200, l'ensemble 212 a une valeur théorique égale à $j'.Comp_u$, avec j' entier compris entre 0 et M3, M3 correspondant au nombre d'associations 216 et j' étant déterminé par les états des interrupteurs 214. En outre, la valeur théorique de l'ensemble 212 s'ajoute à la valeur théorique des ensembles 204 et 206. M3 est par exemple au moins égal à 1/P, de préférence égal à 1/P lorsque P est égal à 1/R avec R entier. Dans cet exemple, M3 est égal à 8.

A titre d'exemple, dans le cas d'un composant Comp et de composants $Comp_{corr}$ résistifs, dans chaque association 216, l'interrupteur 214 est connecté en parallèle du composant $Comp_{corr}$, et les M3 associations 216 sont connectées en série les unes avec les autres. L'association en série des M3 associations 216 est alors connectée en série avec l'association en série des M1 composants $Comp_u$ de l'ensemble 204 et avec l'association en série des M2 associations 210 de l'ensemble 206. Autrement dit, les ensembles 204, 206 et 212 sont connectés en série entre les bornes 200 et 202.

Selon un autre exemple, dans le cas d'un composant Comp et de composants $Comp_{corr}$ capacitifs, dans chaque association 216, l'interrupteur 214 est connecté en série avec le composant $Comp_{corr}$, et les M3 associations 216 sont connectées en parallèle les unes avec les autres. L'association en parallèle des M3 associations 216 est alors connectée en parallèle avec l'association en parallèle des M1 composants $Comp_u$ de l'ensemble 204 et avec l'association en parallèle des M2 associations 210 de l'ensemble 206. Autrement dit, les ensembles 204, 206 et 212 sont connectés en parallèle les uns des autres, entre les bornes 200 et 202.

Ainsi, entre les bornes 200 et 202, le composant Comp a une valeur théorique $Comp\_t$ égale à $M1.Comp_u\_t + j.Comp_u\_t + j'.Comp_{corr}\_t$, avec j déterminé par la combinaison d'états ouverts ou fermés des M2 interrupteurs 208 et j' déterminé par la combinaison d'états ouverts ou fermés des M3 interrupteurs 214. Dit autrement, le composant Comp peut prendre plusieurs valeurs, chaque valeur étant déterminée par une combinaison des états des interrupteurs 208 et 214. Plus particulièrement, la valeur théorique $Comp\_t$ minimale est alors égale à $M1.Comp_u\_t$, la valeur théorique $Comp\_t$ maximale étant alors égale à $(M1+M2).Comp\_t + M3.Comp_{corr}\_t$. La différence entre ces valeurs théoriques maximale et minimale correspond à l'amplitude maximale de la correction possible sur la valeur du composant Comp.

Dans ce mode de réalisation, tous les composants de correction $Comp_{corr}$ ont une valeur théorique $Comp_{corr}\_t$ égale à $(1-P).Comp_u\_t$, c'est-à-dire à 7/8 de la valeur $Comp_u\_t$ dans cet exemple.

Dans ce mode de réalisation où tous les composants de correction $Comp_{corr}$ ont la même valeur $Comp_{corr}\_t$, M3 est de préférence choisi pour que P.M3 soit supérieur ou égal à 1, de préférence égal à 1, M3 étant égal à 8 dans cet exemple.

On considère à titre d'exemple le cas où l'on souhaite obtenir un composant Comp dont la valeur pratique $Comp\_p$, après une éventuelle correction, est égale à une valeur visée de $128.Comp_u\_t$. Dans cet exemple, on considère en outre que M1 est égal à 120, M2 est égal à 8 et M3 est égal 8. Sans dispersions de fabrication, cette valeur visée du composant Comp est obtenue pour une configuration, ou combinaison, nominale des états des interrupteurs 208 et 214. Dans cette configuration nominale, les interrupteurs 208 sont tous dans un même état de sorte que la valeur pratique de l'ensemble 206 est égale à $8.Comp_u\_p$, et les interrupteurs 214 sont tous dans un même état de sorte que la valeur de l'ensemble 212 est égale à $0.Comp_{corr}\_p$, donc à $0.Comp_{corr}\_t$. Ainsi, entre les bornes 200 et 202, le composant Comp a, en configuration nominale, une valeur pratique $Comp\_p$ égale à $128.Comp_u\_p$. En l'absence de dispersions de fabrication, la valeur pratique $Comp\_p$ du composant Comp est donc égale à sa valeur visée $Comp\_t$, soit à $128.Comp_u\_t$.

Supposons maintenant, à titre d'exemple, que les composants $Comp_u$ de l'ensemble 204 souffrent de dispersions de fabrication telles que, dans la configuration nominale, la valeur pratique $Comp\_p$ du composant Comp est égale à $128,25.Comp_u\_t$. On considère en outre, à titre d'exemple pour illustrer une correction de la valeur $Comp\_p$ du composant Comp, que, dans l'ensemble 206, les valeurs $Comp_u\_p$ et $Comp_u\_t$ sont égales, et que, dans l'ensemble 212, les valeurs $Comp_{corr}\_p$ et $Comp_{corr}\_t$ sont égales. Pour corriger la valeur pratique $Comp\_p$, deux interrupteurs 208 sont commandés de sorte que les valeurs des composants $Comp_u$ associés ne s'ajoutent plus à la somme des valeurs des composants $Comp_u$ de l'ensemble 204, ou, autrement dit, soient soustraites de la valeur pratique $Comp\_p$ en configuration nominale. En outre, deux interrupteurs 214 sont commandés de sorte que les valeurs des composants associés $Comp_{corr}$ s'ajoutent à la somme des valeurs des composants $Comp_u$ de l'ensemble 204, ou, autrement dit, soient additionnées à la valeur pratique $Comp\_p$ en configuration nominale. Il en résulte que la valeur pratique $Comp\_p$ du composant Comp après correction est alors égale à la valeur pratique $Comp\_p$ en configuration nominale moins $2.Comp_u\_t$ plus $2.Comp_{corr}\_t$, donc à $128,25.Comp_u\_t - 0,25.Comp_u\_t$, donc à la valeur visée $Comp\_t$ égale à $128.Comp_u\_t$.

Les inventeurs ont constaté, lorsque toutes les valeurs théoriques $Comp\_t$ possibles du composant Comp entre les bornes 200 et 202 sont ordonnées par ordre croissant de valeur, qu'il existe une plage de valeurs dans laquelle un écart, ou pas, constant égal à $P.Comp_u\_t$ sépare chaque deux valeurs successives de cette plage. En outre, cette plage est sensiblement centrée sur la valeur visée $M.Comp_u\_t$ du composant Comp. Dans cette plage, la valeur pratique $Comp\_p$ du composant Comp peut donc être corrigée pour être égale à $M.Comp_u\_t$ avec une précision égale à $P.Comp_u\_t$.

Du fait que la plage susmentionnée est sensiblement centrée sur la valeur visée du composant Comp, la correction de la valeur pratique du composant Comp décrite ci-dessus est adaptée aux distributions gaussiennes des dispersions de fabrication.

Dans un autre mode de réalisation, tous les composants de correction $Comp_{corr}$ ont une même valeur théorique $Comp_{corr}\_t$ égale à $(1+P).Comp_u\_t$, c'est-à-dire à 9/8 de la valeur théorique $Comp_u\_t$ dans cet exemple.

Un avantage des composants de correction $Comp_{corr}$ de valeur théorique $Comp_{corr}\_t$ égale à $(1+P).Comp_u\_t$, par rapport à des composants de correction $Comp_{corr}$ de valeur théorique $Comp_{corr}\_t$ égale à $(1-P).Comp_u\_t$, est qu'ils sont moins sujets aux dispersions de fabrication, bien qu'ils occupent une plus grande surface.

On a décrit ci-dessus un exemple de correction de la valeur $Comp\_p$ du composant Comp en considérant des dispersions de fabrication nulles sur les composants $Comp_u$ de l'ensemble 206 et sur les composants $Comp_{corr}$ de l'ensemble 212. En pratique, ces composants sont également sujets aux dispersions de fabrication. Ainsi, le choix des composants $Comp_{corr}$ de l'ensemble 212 et des composants $Comp_u$ de l'ensemble 206 dont les valeurs s'ajoutent, entre les bornes 200 et 202, à la valeur de l'ensemble 204, est de préférence réalisé en tenant compte de ces dispersions. Il en résulte que la valeur pratique du composant Comp peut être corrigée avec la précision voulue. Plus particulièrement, entre les bornes 200 et 202, il est possible de sélectionner tout ou partie des M2 composants $Comp_u$ de l'ensemble 206 et tout ou partie des M3 composants $Comp_{corr}$ de l'ensemble 212, ce qui conduit à $2^{(M2+M3)}$ combinaisons possibles de correction en tenant compte des dispersions de fabrication sur ces composants $Comp_u$ et $Comp_{corr}$. Dans l'exemple précédant, cela conduit à 65536 combinaisons possibles de correction.

On reprend l'exemple de correction décrit ci-dessus, mais en considérant désormais des dispersions de fabrication sur les composants $Comp_u$ de l'ensemble 206 et sur les composants $Comp_{corr}$ de l'ensemble 212, éventuellement différentes entre ces divers composants. Dans cet exemple, les deux composants $Comp_u$ à désélectionner dans l'ensemble 206 sont choisis parmi les huit composants $Comp_u$ de l'ensemble 206, et les deux composants $Comp_{corr}$ à sélectionner dans l'ensemble 212 sont choisis parmi les huit composants $Comp_{corr}$ de l'ensemble 212. Il existe alors $(8.7).(8.7)=3136$ combinaisons possibles d'états des interrupteurs 208 et 214 conduisant à la désélection de deux composants $Comp_u$ dans l'ensemble 206 et à la sélection de deux composants $Comp_{corr}$ dans l'ensemble 212. Chacune de ces 3136 combinaisons peut conduire à une valeur pratique $Comp\_p$ corrigée différente. Le choix des composants à sélectionner et des composants à désélectionner, ou autrement dit le choix de la combinaison des états des interrupteurs 208 et 214, est alors effectué de sorte que la valeur pratique $Comp\_p$ corrigée correspondante soit aussi proche que possible de la valeur visée $Comp\_t$ du composant Comp.

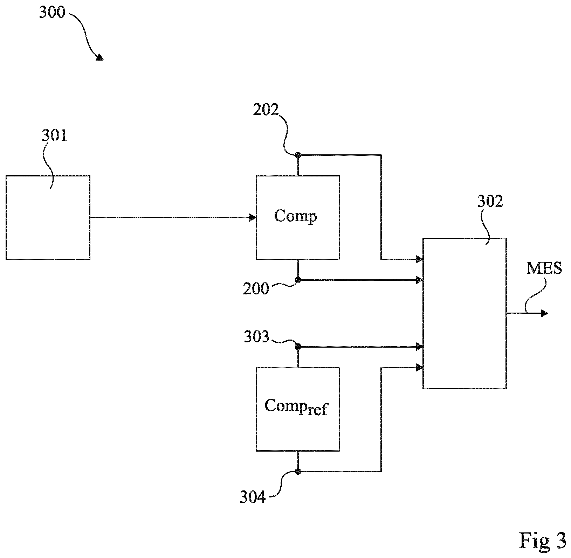

La figure 3 représente, schématiquement et sous la forme de blocs, un mode de réalisation d'un circuit électronique 300 comprenant le composant Comp de la figure 2.

Dans ce mode de réalisation, le circuit 300 est configuré pour mettre en oeuvre une étape de correction de la valeur pratique Comp_p du composant Comp de sorte que sa valeur pratique Comp_p corrigée soit égale, avec un écart d'au plus $P.Comp_u\_t$, à la valeur pratique $Comp_{ref}\_p$ d'un composant de référence $Comp_{ref}$ de valeur théorique $Comp_{ref}\_t$ égale à la valeur théorique $Comp\_t$ du composant Comp. Autrement dit, on cherche ici à appairer le composant Comp avec le composant $Comp_{ref}$.

Ainsi, dans ce mode de réalisation, le circuit 300 comprend non seulement le composant Comp et mais également le composant $Comp_{ref}$.

Le circuit 300 comprend en outre un circuit de commande 301. Le circuit de commande 301 est configuré pour fournir les signaux de commande des interrupteurs 208 et 214 (non représentés en figure 3) du composant Comp. Plus particulièrement, le circuit 301 est configuré pour commander ces interrupteurs 208 et 214 de manière à sélectionner, ou mettre en oeuvre, l'une quelconque des combinaisons d'états des interrupteurs 208 et 214.

Le circuit 300 comprend en outre un circuit 302 de mesure. Le circuit 302 est configuré pour fournir un signal MES représentatif de l'écart entre la valeur pratique Comp_p du composant Comp et, dans ce mode de réalisation, la valeur pratique $Comp_{ref}\_p$ du composant $Comp_{ref}$. Plus particulièrement, le circuit 302 reçoit un signal représentatif de la valeur Comp_p, et, dans ce mode de réalisation, un signal représentatif de la valeur $Comp_{ref}\_p$. Dans cet exemple, le circuit 302 est connecté aux bornes 200 et 202 du composant Comp pour recevoir la tension présente aux bornes du composant Comp, par exemple quand un courant constant est fourni au composant Comp, cette tension étant représentative de la valeur Comp_p. Dans cet exemple, le circuit 301 est en outre connecté à des bornes 303 et 304 du composant $Comp_{ref}$ pour recevoir la tension présente aux bornes du composant $Comp_{ref}$, par exemple quand le même courant constant que celui fourni au composant Comp est fourni au composant $Comp_{ref}$, cette tension étant représentative de la valeur $Comp_{ref}\_p$. Le circuit 302 fournit alors un signal MES représentatif de l'écart entre la tension aux bornes du composant Comp et la tension aux bornes du composant $Comp_{ref}$, c'est-à-dire un signal MES représentatif de l'écart entre les valeurs pratiques Comp_p et $Comp_{ref}\_p$ de ces composants.

En pratique, notamment dans le cas de composants $Comp_{ref}$ et Comp capacitifs, l'une des bornes 200 et 202, et l'une des bornes 303 et 304 peuvent être connectés à une borne d'application d'un potentiel de référence, par exemple la masse ou une tension de mode commun.

En fonctionnement, lors d'une phase de mesure, ou de caractérisation, du composant Comp, le circuit 301 commande les interrupteurs 208 et 214 de manière à sélectionner successivement plusieurs des combinaisons possibles d'états des interrupteurs 208 et 214, de préférence toutes les combinaisons possibles. Pour chaque combinaison sélectionnée, le circuit 302 fournit alors un signal MES représentatif de l'écart entre les valeurs pratiques Comp_p et $Comp_{ref}\_p$ de cette combinaison. Pour chaque combinaison sélectionnée, le signal MES correspondant tient compte des dispersions de fabrication dans le composant $Comp_{ref}$, dans les composants unitaires $Comp_u$ du composant Comp, et dans les composants de correction $Comp_{corr}$ du composant Comp.

Lors d'une phase suivante de correction de la valeur pratique Comp_p du composant Comp, le circuit 301 sélectionne, sur la base des signaux MES obtenus pour les combinaisons sélectionnées d'états des interrupteurs 208 et 214, la combinaison conduisant au plus petit écart entre les valeurs pratiques Comp_p et $Comp_{ref}\_p$ des composants respectifs $Comp_{ref}$ et Comp. En pratique, pour cette combinaison, cet écart est au plus de $P.Comp_u\_t$.

Dans ce mode de réalisation, la valeur pratique Comp-p du composant Comp est donc corrigée par rapport à la valeur pratique $Comp_{ref}\_p$ du composant $Comp_{ref}$, c'est-à-dire en utilisant la valeur $Comp_{ref}\_p$ comme référence. Ce mode de réalisation est particulièrement intéressant lorsque l'on souhaite que les composants Comp et $Comp_{ref}$ aient des valeurs pratiques égales avec une précision égale à $P.Comp_u\_t$.

A titre d'exemple, le composant Comp correspond à la capacité $C_{N-1}$ du CDAC de la figure 1 et le composant $Comp_{ref}$ correspond à la connexion en parallèle de toutes les autres capacités du CDAC, à savoir les capacités $C_{N-2}$, .., $C_k$, .., $C_1$, $C_0$ et $C_u$ du CDAC. En effet pour assurer un fonctionnement correct du CDAC 1, la capacité $C_{N-1}$ doit avoir la même valeur pratique que celle de l'association en parallèle de toutes les autres capacités du CDAC, avec une précision dépendant de la résolution du CDAC. De manière similaire, préalablement à la correction de la valeur de la capacité $C_{N-1}$ en se référant à la valeur de l'association en parallèle de toutes les autres capacités du CDAC 1, on peut prévoir de corriger la valeur de la capacité $C_{N-2}$ en utilisant comme composant de référence $Comp_{ref}$ l'association en parallèle des capacités $C_k$, avec k allant de N-3 à 0, et de la capacité $C_u$. La capacité $C_{N-2}$ est alors mise en oeuvre sous la forme d'un composant Comp tel que décrit en relation avec la figure 2. Plus généralement, on peut prévoir de corriger chaque capacité $C_k$ du CDAC, avec k allant de 1 à N-1, en utilisant comme composant de référence $Comp_{ref}$ l'association en parallèle de la capacité $C_u$ et des capacités $C_0$ à $C_{k-1}$, chaque capacité $C_k$ du CDAC, avec k allant de 1 à N-1, étant alors mise en oeuvre sous la forme d'un composant Comp correspondant tel que décrit en relation avec la figure 2.

Dans une variante de réalisation non illustrée, plutôt que de corriger la valeur Comp_p du composant Comp par rapport à la valeur Comp$_{ref}$_p d'un composant de référence Comp$_{ref}$, on prévoit de corriger la valeur Comp_p directement par rapport à la valeur cible du composant Comp, en pratique égale à sa valeur théorique Comp_t. Dans cette variante, le composant Comp$_{ref}$ peut être omis du circuit 300.

Selon une première mise en oeuvre, le circuit 302 est configuré pour déterminer la valeur pratique Comp_p du composant Comp à partir du signal représentatif de cette valeur que le circuit 302 reçoit, puis pour fournir un signal MES représentatif de l'écart entre la valeur cible et la valeur pratique du composant Comp. En particulier, la valeur cible Comp_t peut être enregistrée dans une mémoire du circuit 300, par exemple une mémoire du circuit 302.

Selon une deuxième mise en oeuvre, le circuit 302 reçoit un signal représentatif de la valeur cible Comp_t du composant Comp et compare ce signal au signal représentatif de la valeur pratique Comp_p du composant Comp. Le circuit 302 est alors configuré pour fournir un signal MES représentatif de l'écart entre ces deux signaux, donc de l'écart entre la valeur pratique Comp_p et la valeur cible Comp_t du composant Comp.

Dans ces deux mises en oeuvre, après une phase de caractérisation similaire à celle décrite précédemment, le circuit 301 sélectionne, sur la base des signaux MES obtenus, la combinaison d'états des interrupteurs 208 et 214 conduisant au plus petit écart entre les valeurs pratique Comp_p et cible Comp_t du composant Comp. En pratique, pour cette combinaison, cet écart est au plus de P.Comp$_u$_t.

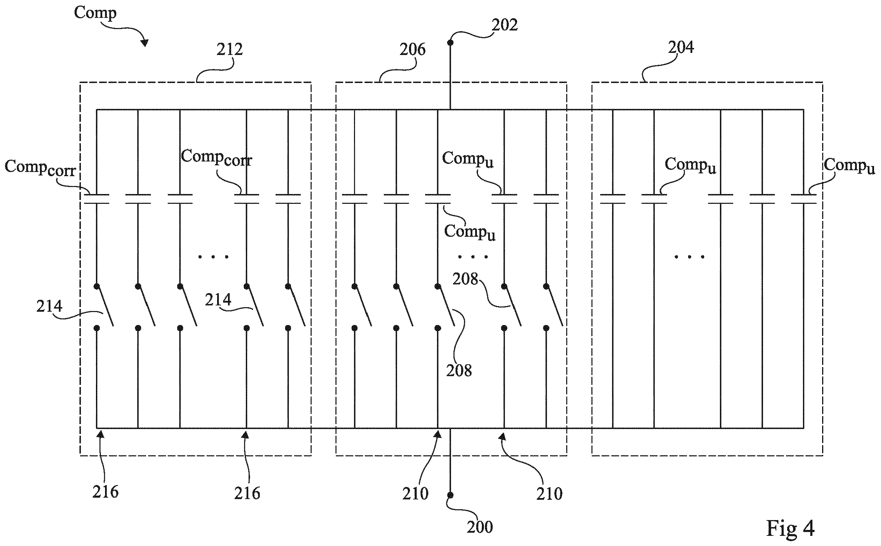

La figure 4 représente, de manière plus détaillée, un mode de réalisation d'un composant du type de celui de la figure 2, dans le cas où le composant est de type capacitif.

Dans cet exemple, le composant Comp comprend les ensembles 204, 206 et 212 connectés en parallèle entre ses bornes 200 et 202. En effet, dans cet exemple, les ensembles 204, 206 et 212 sont capacitifs, et leur connexion en parallèle entre les bornes 200 et 202 revient à ajouter leurs valeurs les unes aux autres. La valeur de capacité vue entre les bornes 200 et 202 est alors égale à la somme des valeurs des capacités équivalentes des ensembles 204, 206 et 212.

Dans l'ensemble 204, les M1 capacités unitaires Comp$_u$, par exemple M1 capacités unitaires $C_u$ décrites en relation avec la figure 1, sont connectées en parallèle les unes des autres de sorte que leurs valeurs s'ajoutent, c'est-à-dire s'additionnent. Ainsi, entre les bornes 200 et 202, l'ensemble 204 a une valeur de capacité égale à M1.Comp$_u$_p.

Dans l'ensemble 206, dans chaque association 210 d'un interrupteur 208 et d'une capacité unitaire Comp$_u$, par exemple une capacité unitaire $C_u$ décrite en relation avec la figure 1, l'interrupteur 208 est connecté en série avec la capacité unitaire Comp$_u$. En outre, les M2 associations 210 sont connectées en parallèle les unes des autres, entre les bornes 200 et 202. Ainsi, lorsque l'interrupteur 208 d'une association 210 donnée est ouvert, la valeur de la capacité unitaire Comp$_u$ de cette association ne s'ajoute pas à la valeur de l'ensemble 204, et, à l'inverse, lorsque l'interrupteur 208 est fermé, la valeur de la capacité unitaire Comp$_u$ s'ajoute à la valeur de l'ensemble 204.

Dans l'ensemble 212, dans chaque association 216 d'une capacité de correction Comp$_{corr}$ et d'un interrupteur 214, l'interrupteur 214 est connecté en série avec la capacité de correction Comp$_{corr}$. En outre, les M3 associations 216 sont connectées en parallèle les unes des autres, entre les bornes 200 et 202. Ainsi, lorsque l'interrupteur 214 d'une association 216 donnée est ouvert, la valeur de la capacité de correction Comp$_{corr}$ de cette association ne s'ajoute pas à la valeur de l'ensemble 204, et, à l'inverse, lorsque l'interrupteur 216 est fermé, la valeur de la capacité de correction Comp$_{corr}$ s'ajoute à la valeur de l'ensemble 204.

La structure du composant de la figure 4 est compatible avec une mise en oeuvre au moyen de capacités unitaires $C_u$ et de correction Comp$_{corr}$ à doigts, notamment lorsqu'elles possèdent une armature ou électrode commune.

A titre d'exemple, on prévoit qu'au moins la capacité $C_{N-1}$ du CDAC de la figure 1 soit mise en oeuvre au moyen du composant capacitif de la figure 4.

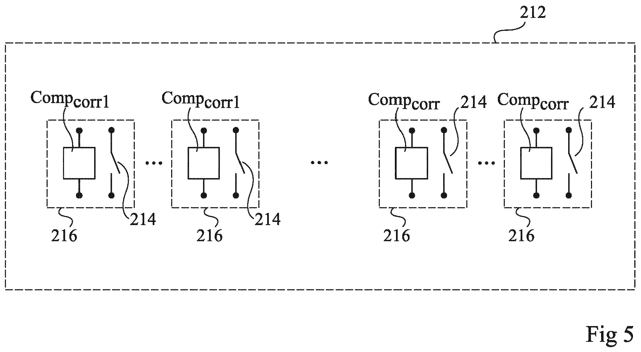

La figure 5 représente schématiquement une variante de réalisation d'un composant du type de celui de la figure 2, seul l'ensemble 212 du composant Comp étant représenté dans cette figure.

Dans cette variante, contrairement aux modes de réalisation et variantes décrits précédemment où les composants Comp$_{corr}$ de l'ensemble 212 ont tous la même valeur théorique Comp$_{corr}$_t égale à (1+P) .Comp$_u$_t ou à (1-P) .Comp$_u$_t, on prévoit que l'ensemble 212 comprenne en outre des composants de correction supplémentaires, référencés ici Comp$_{corr1}$, ayant une valeur théorique Comp$_{corr1}$_t différente de celle des composants Comp$_{corr}$. Les composants Comp$_{corr1}$ sont, comme les composants Comp$_{corr}$, associés chacun à un interrupteur 214 dont l'état détermine si la valeur du composant Comp$_{corr1}$ s'ajoute ou non à la somme des valeurs des composants Comp$_u$ de l'ensemble 204 (non représenté) et à la somme des valeurs des composants Comp$_u$ sélectionnés de l'ensemble 206 (non représenté). Autrement dit, l'ensemble 212 comprend M3 associations 216 dont certaines sont réalisées chacune avec un composant Comp$_{corr}$, les autres étant réalisées chacune avec un composant Comp$_{corr1}$ à la place du composant Comp$_{corr}$.

Plus particulièrement, selon une première variante, les composants Comp$_{corr}$ ont une valeur théorique égale à (1+P) .Comp$_u$_t, et les composants Comp$_{corr1}$ ont une valeur théorique égale à (1-P).Comp$_u$_t.

Selon une deuxième variante, les composants Comp$_{corr}$ ont une valeur théorique égale à (1+P) .Comp$_u$_t, et les composants Comp$_{corr1}$ ont une valeur théorique égale à $(1+P_1) \cdot Comp_u\_t$, avec $P_1$ différent de P. Dans cette deuxième variante, ce qui a été indiqué en relation avec P s'applique à $P_1$. Autrement dit, $P_1$ est strictement positif et strictement inférieur à 1/2. De préférence, $P_1$ est supérieur à 1/20, voire à 1/10. De préférence, $P_1$ est inférieur à 1/3, voire à 1/4.

Cette deuxième variante permet, dans le cas où la précision recherchée sur la valeur Comp_p du composant Comp est égale à $P \cdot Comp_u\_t$ et que P est inférieur à P1, de réduire le nombre total de composants de correction $Comp_{corr}$ et $Comp_{corr1}$ permettant d'obtenir une valeur Comp_p corrigée avec la précision voulue par rapport au cas où seuls des composants $Comp_{corr}$ sont utilisés. Par exemple, quand $P_1$ est égal à A.P, avec A strictement supérieur à 1, au lieu de prévoir au moins 1/P composants $Comp_{corr}$, on peut prévoir au moins A composants $Comp_{corr}$ et au moins $1/P_1$ composants $Comp_{corr1}$, voire moins de 1/P1 composants $Comp_{corr1}$. Par exemple, avec P égal à 1/10 et $P_1$ égal 3/10, donc à 3.P, 3 composants $Comp_{corr}$ et 3 composants $Comp_{corr1}$ suffisent pour corriger la valeur Comp_p avec une précision de $P \cdot Comp_u\_t$.

Ce qui est indiqué ci-dessus reste vrai lorsque P est supérieur à $P_1$, P est égal à $A.P_1$ et la précision recherchée est $P_1 \cdot Comp_u\_t$, au moins A composants $Comp_{corr1}$ et au moins 1/P composants $Comp_{corr}$, voire moins de 1/P composants $Comp_{corr}$, étant alors prévus.

Selon une troisième variante de réalisation, les composants $Comp_{corr}$ ont une valeur théorique égale à $(1-P) \cdot Comp_u\_t$, et les composants $Comp_{corr1}$ ont une valeur théorique égale à $(1-P_1) \cdot Comp_u\_t$, avec $P_1$ différent de P. Dans cette deuxième variante, ce qui a été indiqué en relation avec P s'applique à $P_1$. Comme pour la deuxième variante de réalisation, quand P est inférieur à $P_1$, la troisième variante de réalisation permet de réduire le nombre de composants de correction suffisant à corriger la valeur Comp_p avec une précision de $P \cdot Comp_u\_t$, par rapport au cas où seuls des composants $Comp_{corr}$ sont utilisés. Ce qui est indiqué ci-dessus reste vrai lorsque P est supérieur à $P_1$ et que la précision recherchée est $P_1 \cdot Comp_u\_t$.

Dans les deuxièmes et troisièmes variantes décrites en relation avec la figure 5, la précision visée sur la valeur pratique Comp_p corrigée du composant Comp est au moins en partie déterminée par la valeur du plus petit des nombres P et $P_1$.

En outre, dans les variantes de réalisation décrites en relation avec la figure 5, l'homme du métier est en mesure de déterminer, parmi les M3 associations 216, lesquelles sont réalisées avec un composant de correction $Comp_{corr}$, et lesquelles sont réalisées avec un composant de correction $Comp_{corr1}$.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, on peut prévoir un composant Comp dans lequel certaines associations 216 de l'ensemble 212 comprennent des composants de correction $Comp_{corr}$ de valeur théorique $Comp_{corr}\_t$ égale à $(1+P) \cdot Comp_u\_t$, et dans lequel les autres associations 216 de l'ensemble sont réalisées avec des composants de correction $Comp_{corr1}$ de valeur théorique $Comp_{corr1}\_t$ égale à $(1-P_1) \cdot Comp_u\_t$, avec $P_1$ différent de P.

Enfin, la mise en oeuvre pratique des modes de réalisation et variantes décrits est à la portée de l'homme du métier à partir des indications fonctionnelles données ci-dessus. En particulier, l'homme du métier est en mesure de choisir les valeurs M1, M2 et M3 et/ou la ou les valeurs théoriques des composants de correction des associations 216 de l'ensemble 212 en fonction de l'application visée. De même, la mise en oeuvre du circuit 300, et en particulier des circuits 301 et 302, est à la portée de l'homme du métier.

**Revendications**

1. Circuit intégré comprenant un premier composant passif (Comp) de type capacitif, résistif ou inductif comportant :

   une pluralité de deuxièmes et troisièmes composants passifs ($Comp_u$) dudit type ayant chacun une même première valeur théorique $Comp_u\_t$, les deuxièmes composants étant connectés entre eux de sorte que leurs valeurs s'ajoutent,
   et chaque troisième composant étant associé à un premier interrupteur (208) dont l'état détermine si la valeur du troisième composant s'ajoute aux valeurs des deuxièmes composants ; et
   une pluralité de quatrièmes composants passifs ($Comp_{corr}$, $Comp_{corr1}$) dudit type chacun associé à un deuxième interrupteur (214) dont l'état détermine si la valeur du quatrième composant s'ajoute aux valeurs des deuxièmes composants, au moins un ($Comp_{corr}$) des quatrièmes composants ($Comp_{corr}$, $Comp_{corr1}$) passifs ayant une deuxième valeur théorique égale à $(1-P) \cdot Comp_u\_t$ ou à $(1+P) \cdot Comp_u\_t$, avec P positif strictement inférieur à 1/2.

2. Circuit selon la revendication 1, dans lequel le premier composant a une valeur cible égale à $M \cdot Comp_u\_t$, avec M entier.

3. Circuit selon la revendication 2, dans lequel $P \cdot Comp_u\_t$ détermine un écart maximal désiré entre une valeur pratique et une valeur cible du premier composant (Comp) ou une valeur pratique d'un cinquième composant ($Comp_{ref}$) passif, les premier et cinquième composants ayant la même valeur cible et étant du même type.

**4.** Circuit selon la revendication 3, comprenant en outre un circuit de mesure (302) configuré pour fournir un signal (MES) représentatif d'un écart entre la valeur pratique du premier composant (Comp) et la valeur cible du premier composant ou la valeur pratique du cinquième composant ($Comp_{ref}$).

**5.** Circuit selon l'une quelconque des revendications 1 à 4, comprenant en outre un circuit de commande (301) des premiers (208) et deuxièmes (214) interrupteurs, configuré pour sélectionner l'une quelconque des combinaisons possibles d'états des premiers (208) et deuxièmes (214) interrupteurs.

**6.** Circuit selon la revendication 5, dans lequel, dans une phase de caractérisation du premier composant (Comp), le circuit de commande (301) est configuré pour sélectionner successivement au moins certaines desdites combinaisons possibles d'états des premiers (208) et deuxièmes (214) interrupteurs.

**7.** Circuit selon les revendications 4 et 6, dans lequel, dans une phase de correction, le circuit de commande (301) est configuré pour sélectionner parmi les combinaisons sélectionnées pendant la phase de caractérisation, à partir du signal (MES) fourni par le circuit de mesure (302) pour chaque combinaison sélectionnée pendant la phase de caractérisation, une combinaison d'états des premiers (208) et deuxièmes (214) interrupteurs correspondant à la valeur pratique du premier composant (Comp) la plus proche de la valeur cible ou de la valeur pratique du cinquième composant ($Comp_{ref}$).

**8.** Circuit selon l'une quelconque des revendications 1 à 7, dans lequel lesdits composants (Comp, $Comp_u$, $Comp_{corr}$, $Comp_{corr1}$, $Comp_{ref}$) sont de type capacitif, les deuxièmes composants ($Comp_u$) étant connectés en parallèle les uns des autres, chaque troisième composant ($Comp_u$) étant connecté en série avec le premier interrupteur (208) auquel le troisième composant est associé, chaque quatrième composant ($Comp_{corr}$, $Comp_{corr1}$) étant connecté en série avec le deuxième interrupteur (214) auquel le quatrième composant est associé, chaque association (210) en série d'un troisième composant ($Comp_u$) et d'un interrupteur (208) et chaque association (216) en série d'un quatrième composant ($Comp_{corr}$, $Comp_{corr1}$) et d'un interrupteur (214) étant connectées en parallèle des deuxièmes composants ($Comp_u$).

**9.** Circuit selon l'une quelconque des revendications 1 à 8, dans lequel P est inférieur ou égal à 1/3.

**10.** Circuit selon l'une quelconque des revendications 1 à 9, dans lequel P est égal à 1/R, avec R entier.

**11.** Circuit selon la revendication 10 prise dans sa dépendance à la revendication 2, comprenant M-R deuxièmes composants ($Comp_u$) et R troisièmes composants ($Comp_u$).

**12.** Circuit selon la revendication 11, comprenant R quatrièmes composants ($Comp_{corr}$) .

**13.** Circuit selon l'une quelconque des revendications 1 à 12, dans lequel tous les quatrièmes composants ($Comp_{corr}$) ont la même deuxième valeur théorique.

**14.** Convertisseur numérique analogique (1) comprenant un circuit intégré (300) selon l'une quelconque des revendications 1 à 13.

**Patentansprüche**

**1.** Eine integrierte Schaltung, die ein erstes passives Bauteil bzw. Komponente (Comp) vom kapazitiven, resistiven oder induktiven Typ aufweist, Folgendes aufweisend:

eine Vielzahl von zweiten und dritten passiven Bauteilen bzw. Komponenten ($Comp_u$) des genannten Typs, die jeweils den gleichen ersten theoretischen Wert $Comp_u\_t$ haben, wobei die zweiten Bauteile so miteinander verbunden sind, dass sich ihre Werte addieren, und wobei jedes dritte Bauteil mit einem ersten Schalter (208) verbunden ist, dessen Zustand bestimmt, ob sich der Wert des dritten Bauteils zu den Werten der zweiten Bauteile addiert; und eine Vielzahl von vierten passiven Bauteilen bzw. Komponenten ($Comp_{corr}$, $Comp_{corr1}$) des genannten Typs, die jeweils einem zweiten Schalter (214) zugeordnet sind, dessen Zustand bestimmt, ob sich der Wert des vierten Bauteils zu den Werten der zweiten Bauteile addiert, wobei mindestens eines ($Comp_{corr}$) der vierten passiven Bauteile ($Comp_{corr}$, $Comp_{corr1}$) einen zweiten theoretischen Wert hat, der gleich (1-P).$Compu\_t$ oder (1+P).$Comp_u\_t$ ist, wobei P positiv und streng kleiner als 1/2 ist.

**2.** Die Schaltung nach Anspruch 1, wobei das erste Bauteil einen Zielwert gleich M.$Comp_u\_t$ hat, wobei M eine ganze Zahl ist.

**3.** Die Schaltung nach Anspruch 2, wobei P.$Comp_u\_t$ eine maximal gewünschte Differenz zwischen einem praktischen Wert und einem Zielwert des ersten Bauteils (Comp) oder einem praktischen Wert eines fünften passiven Bauteils bzw. Komponente ($Comp_{ref}$) bestimmt, wobei das erste und das fünfte Bauteil denselben Zielwert haben und vom selben Typ sind.

**4.** Die Schaltung nach Anspruch 3, die ferner eine Messschaltung (302) aufweist, die eingerichtet ist, ein Signal (MES) zu liefern, das eine Differenz zwischen dem praktischen Wert des ersten Bauteils (Comp) und dem Zielwert des ersten Bauteils oder dem praktischen Wert des fünften Bauteils (Comp$_{ref}$) darstellt.

**5.** Die Schaltung nach einem der Ansprüche 1 bis 4, die ferner eine Steuerschaltung (301) zur Steuerung des ersten (208) und des zweiten (214) Schalters aufweist, die eingerichtet ist, eine der möglichen Kombinationen von Zuständen des ersten (208) und des zweiten (214) Schalters auszuwählen.

**6.** Die Schaltung nach Anspruch 5, wobei die Steuerschaltung (301) in einer Phase der Charakterisierung des ersten Bauteils (Comp) eingerichtet ist, nacheinander mindestens einige mögliche Kombinationen der Zustände des ersten (208) und des zweiten (214) Schalters auszuwählen.

**7.** Die Schaltung nach Anspruch 4 und 6, wobei die Steuerschaltung (301) in einer Korrekturphase eingerichtet ist, unter den während der Charakterisierungsphase ausgewählten Kombinationen auf der Grundlage des von der Messschaltung (302) für jede während der Charakterisierungsphase ausgewählte Kombination gelieferten Signals (MES) eine Kombination von Zuständen des ersten (208) und des zweiten (214) Schalters auszuwählen, die dem praktischen Wert des ersten Bauteils (Comp), der dem Zielwert am nächsten ist, oder dem praktischen Wert des fünften Bauteils (Comp$_{ref}$) entspricht.

**8.** Die Schaltung nach einem der Ansprüche 1 bis 7, wobei die genannten Bauteile (Comp, Comp$_u$, Comp$_{corr}$, Comp$_{corr1}$, Comp$_{ref}$) vom kapazitiven Typ sind, wobei die zweiten Bauteile (Comp$_u$) parallel zueinander geschaltet sind, wobei jedes dritte Bauteil (Comp$_u$) in Reihe mit dem ersten Schalter (208) geschaltet ist, dem das dritte Bauteil zugeordnet ist, wobei jedes vierte Bauteil (Comp$_{corr}$, Comp$_{corr1}$) mit dem zweiten Schalter (214) in Reihe geschaltet ist, dem das vierte Bauteil zugeordnet ist, wobei jede Reihenschaltung (210) eines dritten Bauteils (Comp$_u$) und eines Schalters (208) und jede Reihenschaltung (216) eines vierten Bauteils (Comp$_{corr}$, Comp$_{corr1}$) und eines Schalters (214) parallel zu den zweiten Bauteilen (Comp$_u$) geschaltet ist.

**9.** Die Schaltung nach einem der Ansprüche 1 bis 8, wobei P kleiner als oder gleich 1/3 ist.

**10.** Die Schaltung nach einem der Ansprüche 1 bis 9, wobei P gleich 1/R ist, wobei R eine ganze Zahl ist.

**11.** Die Schaltung nach Anspruch 10, und zwar in ihrer Abhängigkeit von Anspruch 2, die M-R zweite Bauteilen (Comp$_u$) und R dritte Bauteile (Comp$_u$) aufweist.

**12.** Die Schaltung nach Anspruch 11, die R vierte Bauteile (Comp$_{corr}$) aufweist.

**13.** Die Schaltung nach einem der Ansprüche 1 bis 12, wobei alle vierten Bauteile (Comp$_{corr}$) denselben zweiten theoretischen Wert haben.

**14.** Ein Digital-Analog-Wandler (1), der die integrierte Schaltung (300) nach einem der Ansprüche 1 bis 13 aufweist.

**Claims**

**1.** An integrated circuit comprising a first passive component (Comp) of capacitive, resistive, or inductive type comprising:

a plurality of second and third passive components (Comp$_u$) of said type, each having a same first theoretical value Comp$_u$_t, the second components being connected together so that their values add, and each third component being associated with a first switch (208) having its state determining whether the value of the third component adds to the values of the second components; and a plurality of fourth passive components (Comp$_{corr}$, Comp$_{corr1}$) of said type, each associated with a second switch (214) having its state determining whether the value of the fourth component adds to the values of the second components, at least one (Comp$_{corr}$) of the fourth passive components (Comp$_{corr}$, Comp$_{corr1}$) having a second theoretical value equal to (1-P) .Comp$_u$_t or to (1+P) .Comp$_u$_t, P being positive and strictly smaller than 1/2.

**2.** The circuit according to claim 1, wherein the first component has a target value equal to M.Compu_t, M being an integer.

**3.** The circuit according to claim 2, wherein P.Compu_t determines a maximum desired difference between a practical value and a target value of the first component (Comp) or a practical value of a fifth passive component (Compref), the first and fifth components having the same target value and being of the same type.

**4.** The circuit according to claim 3, further comprising a measurement circuit (302) configured to deliver a signal (MES) representative of a difference between the practical value of the first component (Comp) and the target value of the first component or the practical value of the fifth component (Compref).

5. The circuit according to any of claims 1 to 4, further comprising a control circuit (301) for controlling the first (208) and second (214) switches, configured to select any of the possible combinations of states of the first (208) and second (214) switches.

6. The circuit according to claim 5, wherein, in a phase of characterization of the first component (Comp), the control circuit (301) is configured to successively select at least some of said possible combinations of states of the first (208) and second (214) switches.

7. The circuit according to claims 4 and 6, wherein, in a correction phase, the control circuit (301) is configured to select among the combinations selected during the characterization phase, based on the signal (MES) delivered by the measurement circuit (302) for each combination selected during the characterization phase, a combination of states of the first (208) and of second (214) switches corresponding to the practical value of the first component (Comp) closest to the target value or to the practical value of the fifth component (Compref).

8. The circuit according to any of claims 1 to 7, wherein said components (Comp, Compu, Compcorr, Compcorr1, Compref) are of capacitive type, the second components (Compu) being connected in parallel to one another, each third component (Compu) being series-connected to the first switch (208) having the third component associated therewith, each fourth component (Compcorr, Compcorr1) being series-connected to the second switch (214) having the fourth component associated therewith, each series association (210) of a third component (Compu) and of a switch (208) and each series association (216) of a fourth component (Compcorr, Compcorr1) and of a switch (214) being connected in parallel to the second components (Compu).

9. The circuit according to any of claims 1 to 8, wherein P is smaller than or equal to 1/3.

10. The circuit according to any of claims 1 to 9, wherein P is equal to 1/R, R being an integer.

11. The circuit according to claim 10 taken in its dependency to claim 2, comprising M-R second components (Compu) and R third components (Compu).

12. The circuit according to claim 11, comprising R fourth components (Compcorr).

13. The circuit according to any of claims 1 to 12, wherein all the fourth components (Compcorr) have the same second theoretical value.

14. A digital-to-analog converter (1) comprising the integrated circuit (300) according to any of claims 1 to 13.

EP 3 742 616 B1

Fig 1

Fig 2

Fig 3

Fig 4

EP 3 742 616 B1

17

Fig 5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2002034932 A1